# EUROPEAN PATENT APPLICATION

(11) **EP 2 270 260 A1**
(43) Date of publication of application: **05.01.2011**
(21) Application number: 09721192.4
(22) Date of filing: 10.03.2009
(51) Int. Cl.: C25D 7/00, C25D 3/56, C25D 5/12, H01L 23/12, H01L 23/50, H05K 1/09, H05K 3/24

(54) **ELECTRONIC COMPONENT AND METHOD FOR MANUFACTURING THE SAME**

(30) Priority: 19.03.2008 JP 2008071975
(71) Applicant: Matsuda Sangyo Co., Ltd., Shinjuku-Ku Tokyo 163-0558 (JP)
(72) Inventor: TAKAYANAGI, Mamoru, Shinjuku-Ku, Tokyo (JP); ODA, Kazuhiro, Shinjuku-Ku, Tokyo (JP); MICHINO, Takayoshi, Shinjuku-Ku, Tokyo (JP); SUZUKI, Takehiko, Shinjuku-Ku, Tokyo (JP)
(74) Representative: Berryman, Natalia Grace
(86) International application number: PCT/JP2009/054510
(87) International publication number: WO 2009/116426

(57) **Abstract**

Disclosed is an electronic component comprising a connecting terminal part having a surface of an electroconductive base material and a germanium-containing nickel plating film provided on the surface. In the electronic component, the plating film provided on the surface of the electroconductive base material in the connecting terminal part possesses excellent heat resistance and solder wettability.

## Description

### CROSS-REFERENCE TO RELATED APPLICATION

The application is based upon and claims the benefit of priority from the prior Japanese Patent Application No. 071975/2008, filed on March 19, 2008; the entire contents of which are incorporated herein by reference.

### BACKGROUND OF THE INVENTION

### Field of Invention

The present invention relates to an electronic component comprising a connecting terminal part that comprises an electroconductive base material and a germanium-containing nickel plating film provided on the surface of the electroconductive base material. The present invention also relates to a method for manufacturing the electronic component.

### Background Art

Various electronic components such as packages and circuit boards have been utilized as electronic components on which a semiconductor chip or the like can be mounted. Among them, for example, lead frames and BGAs (ball grid arrays) may be mentioned as the package. In such electronic components, soldering or wire bonding has hitherto been used as bonding means. Specifically, the soldering or wire bonding is utilized to bond an electronic component to a semiconductor chip mounted on the electronic component or is utilized for bonding to a connecting terminal in mounting a package to a printed wiring board or the like. For example, in a lead frame, a semiconductor chip is mounted, and wire bonding is applied between an electrode in the semiconductor chip and an inner lead in the lead frame while soldering is applied to an outer lead.

Regarding such electronic component bonding and mounting techniques, for example, Japanese Patent Application Laid-Open Publication No. 8438/1997 discloses that, in a lead frame, a nickel plating film, a palladium plating film, and a gold plating film are formed in that order on the surface of copper as a terminal base material to improve bonding properties in wire bonding and solder bonding terminals.

Further, Japanese Patent Application Laid-Open Publication No. 083410/2006 discloses that, in a method for manufacturing an electronic component in which a soldering part is subjected to surface treatment to form a three-layered structure of nickel, palladium, and gold, an electronic component having good solder wettability can be formed by holding a specific thickness relationship between the palladium layer and the gold layer.

On the other hand, up to now, the applicants of the present invention have proposed a plurality of palladium plating solutions that can be used at a terminal part in an electronic component and possess excellent solder wettability (for example, Japanese Patent Application Laid-Open Publication No. 335986/2001 (USP 6811674 B2) and Japanese Patent Application Laid-Open Publication No. 355093/2001).

Thus, various attempts as an electronic component bonding technique have been made to form a plating film, for example, in a bonding part, for example, from the viewpoint of improving solder wettability of a bonding part or a connecting terminal part.

However, there is still a strong demand for a further size reduction or an enhanced density of packages. To meet this demand, a reduction in film thickness of the bonding part per se or a reduction in area is further required. At the same time, there is a demand for a bonding part or a connecting terminal part that can realize a good bonded state even when the film thickness or size has been further reduced and the bonding part has undergone a high-temperature heat history. Specifically, a bonding part or a connecting terminal part, which can realize a good bonded state even under severer conditions than in the past, is desired. Accordingly, also from the viewpoint of improving a production efficiency, the formation of a bonding part or a connecting terminal part possessing excellent heat resistance and solder wettability, which can realize good bonding even when the bonding part or the connecting terminal part undergoes a high-temperature heat history, has still been desired in the art.

### SUMMARY OF THE INVENTION

The present inventors have now unexpectedly succeeded in significantly improving heat resistance and solder wettability in a three-layered plating film comprising nickel, palladium, and gold provided in that order on a surface of an electroconductive base material in a bonding part of a lead frame by using a germanium-containing nickel film as the nickel plating film. As a result, the present inventors have succeeded in further significantly reducing the thickness of a plating film while maintaining heat resistance and solder wettability comparable with those in the prior art techniques, that is, in further reducing the thickness of a plating film in the bonding part.

The present invention will be described by taking a specific example. In a lead frame as the electronic component, when a three-layered plating film of nickel (Ni)-palladium (Pd)-gold (Au) is formed by adopting a conventional-type nickel plating film free from germanium on the connecting terminal part in the lead frame and using pure palladium and pure gold respectively for the palladium plating film and the gold plating film, in order that the three-layered film achieves a zero crossing time of not more than 2 sec in a solder wettability test using a eutectic solder in the air under heating conditions of 400°C and 30 sec, the thickness of the plating film should be at least about 1 µm for Ni, at least about 0.015 µm for Pd, and at least about 0.007 µm for Au. This value is close to the limit value in the prior art techniques. By contrast, the present inventors have found that, when a nickel plating film is formed using a plating solution prepared by adding germanium to a nickel plating bath, a zero crossing time of not more than 1 sec under heating conditions of 400°C and not less than 100 sec, that is, a heating resistance time, which is at least twice the heating resistance time in the prior art techniques, can be realized in the same plating film thicknesses as those described above. Further, when a zero crossing time of not more than 2 sec is achieved in a solder wettability test using a eutectic solder under heating conditions of 400°C and 30 sec, a Ni plating film thickness of about 0.3 µm, a Pd plating film thickness of about 0.005 µm, and a Au plating film thickness of about 0.005 suffice for the contemplated results. Thus, a significant reduction in plating film thickness as compared with the plating film thickness in the prior art techniques could be realized. It has also been found that these results are more significant with increasing the content of germanium in the nickel plating film.

The present invention has been made based on such finding.

Accordingly, an object of the present invention is to provide an electronic component comprising a plating film, provided on a surface of an electroconductive base material in a connecting terminal part, that possesses excellent heat resistance and solder wettability and can realize a further reduction in film thickness.

According to one aspect of the present invention, there is provided an electronic component characterized in that a germanium-containing nickel plating film is provided on a surface of an electroconductive base material in a connecting terminal part.

According to another aspect of the present invention, there is provided an electrical product comprising the electronic component according to the present invention.

According to a further aspect of the present invention, there is provided a method for manufacturing an electronic component, which comprises forming a germanium-containing nickel plating film on a surface of an electroconductive base material in the connecting terminal part by using a germanium-containing nickel plating bath.

According to the present invention, the heat resistance and solder wettability of a plating film provided on the surface of an electroconductive base material in a connecting terminal part in an electronic component can be significantly improved. Consequently, an electronic component comprising a connecting terminal part possessing excellent heat resistance and solder wettability can be provided. Specifically, according to the present invention, since the heat resistance of the plating film can be improved, the thickness of the plating film per se can be further reduced while maintaining the properties of the plating film. Further, the reduction in plating film thickness can shorten a necessary plating time, contributing to a reduced cost of manufacturing and a further reduction in weight and size of the electronic component. A further reduction in plating film thickness can significantly contribute to the prevention of separation of the plating film upon bending of the member. Accordingly, products in various forms unattainable by the prior art techniques can be proposed.

### BRIEF DESCRIPTION OF THE DRAWINGS

Fig. 1 is a conceptual diagram of a three-layered plating structure comprising Ni, Pd, and Au provided in that order on a conventional lead frame material;
Fig. 2 is a graph showing the relationship between the concentration of germanium in a nickel plating bath and the content of germanium in a nickel plating film formed using nickel plating baths having respective various germanium concentrations;
Fig. 3 is a graph showing the results of an experiment in (2) a) in Example 1, that is, the relationship between the heating time (sec) and the zero crossing time (solder wettability), when an evaluation sample is heated under predetermined conditions;
Fig. 4 is a graph showing the results of an experiment in (2) b) in Example 1, that is, the relationship between the content of germanium in a nickel plating film, and the zero crossing time (solder wettability);
Fig. 5 is a graph showing the relationship between the heating time (sec) and the zero crossing time (solder wettability) for evaluation samples different from each other in nickel plating film thickness;
Fig. 6 is a diagram showing the results (depth profile) of an analysis in the depth-wise direction of a three-layered plating film of an evaluation sample after heat treatment (sample 1, Comparative Example) for the behavior of diffusion of nickel from a nickel layer with an X-ray photoelectron spectroscopic analyzer (XPS); and
Fig. 7 is a diagram showing the results (depth profile) of an analysis in the depth-wise direction of a three-layered plating film of an evaluation sample after heat treatment (sample 5, present invention) for the behavior of diffusion of nickel from a nickel layer with an X-ray photoelectron spectroscopic analyzer (XPS).

### DETAILED DESCRIPTION OF THE INVENTION

### Electronic component

As described above, the electronic component according to the present invention is characterized by comprising the connecting terminal part having a surface of an electroconductive base material and a germanium-containing nickel plating film provided on the surface.

In general, in order to improve the heat resistance of plating films in electronic components, preferably, upon exposure to thermal load, nickel in the nickel plating film on the surface of the electroconductive base material and the main (base) metal (for example, copper) of the electroconductive base material as a substrate is diffused to the outermost surface layer of the plating film and is exposed to the surface of the plating film to prevent the oxidation of the plating film by the air. Methods considered effective for preventing the diffusion of the metal such as nickel include a method in which the nickel plating film is further covered with a palladium plating film and/or a gold plating film and, if necessary, the palladium plating film and/or the gold plating film is improved so as to barrier the diffusion of nickel or the like, or suitable thickness and the like of these films are selected. The improvement in the palladium plating film and the gold plating film is not always said to conform to a tendency toward the reduction in film thickness. On the other hand, there is a strong demand of users for use of pure metals or metals having a purity close to pure metals in the palladium plating film and the gold plating film.

The present inventors have succeeded in effectively preventing the diffusion of nickel in the nickel plating film and the main metal (for example, copper) of the electroconductive base material as the substrate into the surface layer by simply adding germanium to a nickel plating bath in the formation of the nickel plating film. This has been unexpectedly found by the present inventors.

It is generally considered that the nickel plating film according to the present invention is formed by adding germanium to a nickel plating bath and performing nickel plating and germanium is codeposited in the nickel plating film. The present inventors have now found that germanium present in the nickel plating film functions to prevent or delay the diffusion of nickel into the palladium plating film and the gold plating film covering the nickel plating film. Further, the present inventors have found that germanium present in the nickel plating film also has a barrier effect by which the diffusion of the main metal (for example, copper) of the electroconductive base material as the substrate into the surface layer can be suppressed.
The behavior of germanium in the nickel plating film described above includes a theoretical assumption, and the assumption does not limit the present invention.

Specifically, according to the present invention, when a three-layered plating film of nickel (Ni), palladium (Pd), and gold (Au) provided in that order with the nickel plating film being the lowest layer is formed, the palladium plating layer and the gold plating layer may be formed of a pure palladium metal or a palladium metal having a purity close to the pure palladium metal and a pure gold metal or a gold metal having a purity close to the pure gold metal. This is favorable for users and is easily accepted by the users. The adoption of the construction is one of features of the present invention.

In one preferred embodiment of the present invention, the electronic component according to the present invention has a two-layered plating structure comprising a palladium plating film provided on the surface of the nickel plating film or a gold plating film provided on the surface of the nickel plating film. The covering of the nickel plating film with the palladium plating film or the gold plating film can protect the nickel plating film, for example, against corrosion such as oxidation, and, for example, the heat resistance and the solder wettability can be improved.

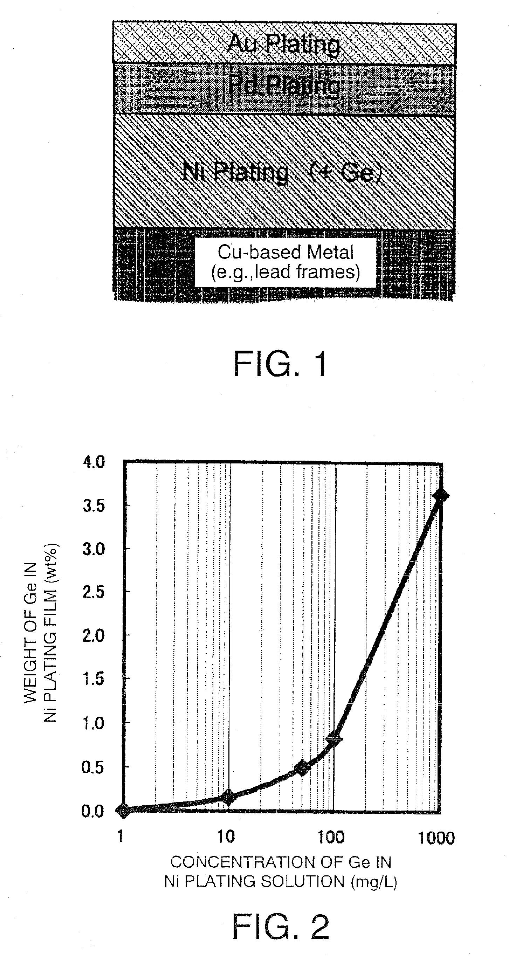

In one more preferred embodiment of the present invention, the electronic component according to the present invention has a three-layered plating structure comprising a palladium plating film provided on the surface of the nickel plating film and a gold plating film provided on the surface of the palladium plating film (for example, see Fig. 1). The three-layered structure can protect the nickel plating film, for example, against corrosion such as oxidation, and, for example, heat resistance and solder wettability can be improved.

In another one preferred embodiment of the present invention, the thickness of the nickel plating film in the electronic component according to the present invention is 0.01 µm to 5 µm, preferably 0.01 µm to 3 µm, more preferably 0.05 µm to 2 µm, still more preferably 0.1 µm to 1 µm, further more preferably 0.3 µm to 1 µm, and particularly preferably 0.5 µm to 1 µm. When the thickness of the nickel plating film is smaller than 0.01 µm, in some cases, the effect of suppressing the diffusion of nickel in the nickel plating film is reduced and, further, ensuring good heat resistance and solder wettability is difficult. On the other hand, a nickel plating film thickness of larger than 5 µm disadvantageously leads to an increased cost and further is unfavorable from the viewpoint of realizing a reduction in weight and size of the product.

In a further one preferred embodiment of the present invention, the content of germanium in the nickel plating film in the electronic component according to the present invention is 0.005 to 10% by weight, preferably 0.005 to 5% by weight, more preferably 0.05 to 5% by weight, still more preferably 0.1 to 4% by weight, further more preferably 0.1 to 1% by weight. When the content of germanium in the nickel plating film is less than 0.005% by weight, in some cases, the effect of suppressing the diffusion of nickel in the nickel plating film is reduced and, further, ensuring good heat resistance and solder wettability is difficult. On the other hand, when the content of germanium in the nickel plating film is more than 5% by weight, the germanium is likely to affect the reliability of wire bonding and the solder bondability.

In one preferred embodiment of the present invention, the connecting terminal part in the electronic component is subjected to soldering or wire bonding.

In one preferred embodiment of the present invention, the electronic component according to the present invention is a package comprising any of a lead frame, an organic substrate, or an inorganic substrate. When the electronic component is a lead frame, a germanium-containing nickel plating film is formed on an inner lead and/or an outer lead in the lead frame. On the other hand, when the electronic component is an organic substrate or an inorganic substrate, a germanium-containing nickel plating film is formed on a part called a pad, a pin, or a land. In an electronic component, particularly in a connecting terminal part in the electronic component, when bonding is carried out by soldering or wire bonding, the formation of a germanium-containing nickel plating film in the bonding part can provide an electronic component having improved heat resistance.

The nickel plating solution contained in the nickel bath for use in the formation of the electronic component according to the present invention may be a conventional nickel plating solution and is not particularly limited. In general, the nickel plating solution contains a soluble nickel salt and a conducting salt. Soluble nickel salts include, for example, nickel acetate, nickel chloride, nickel sulfate, nickel sulfamate, and nickel bromide. The weight of the soluble nickel salt in the nickel plating solution is 1 to 150 g/L, more preferably 10 to 80 g/L, most preferably 10 to 50 g/L, in terms of nickel metal. When the nickel ion concentration is excessively low, a burnt deposit is likely to be formed in a high-current density part in a plated product. On the other hand, when the nickel ion concentration is excessively high, the stability of nickel in the plating solution is lowered. In this case, nickel forms an insoluble compound in the form of a hydroxide. The nickel plating solution may contain a nickel alloy which can form a nickel alloy plating film.
Further, typically, conventional plating baths, for example, a Watts bath or a sulfamic acid bath may be used.

The palladium plating solution for use in the formation of the electronic component according to the present invention may be a conventional palladium planting solution and is not particularly limited. In general, the palladium plating solution contains a soluble palladium salt and a conducting salt. Soluble palladium salts include, for example, palladium chloride, dichlorotetraammine palladium, dibromotetraamine palladium, dinitrotetraammine palladium, diiodotetraammine palladium, palladium tetraammine dinitrite, palladium tetraammine dinitrate, palladium tetraammine disulfite, palladium tetraammine disulfate, chloronitrotetraammine palladium, dichlorodiamine palladium, dibromodiamine palladium, dinitrodiamine palladium, diiodotetradiammine palladium, palladium diammine dinitrite, palladium diammine dinitrate, palladium diammine disulfite, palladium diammine disulfate, chloronitrodiammine palladium, and dichloroethylenediamine palladium. Conducting salts include nitrates, chlorides, sulfates, oxalates, tartrates, hydroxides, boric acid, borates, carbonates, phosphates, and sulfamates. The weight of the soluble palladium salt in the palladium plating solution is 0.1 to 100 g/L in terms of palladium metal. The palladium plating solution may contain a palladium alloy which can form a palladium alloy plating film.

The gold plating solution for use in the formation of the elctronic component according to the present invention may be a conventional gold plating solution and is not particularly limited. In general, the gold plating solution contains a soluble gold salt and a conducting salt. Soluble gold salts include, for example, potassium gold cyanide, chloraurates, and gold sulfites (sodium gold sulfite, pottasium gold sulfite, and ammonium gold sulfite). Conducting salts include citric acid, citrates, phosphates, sulfates, tartrates, oxalates, and boric acid. The weight of the soluble gold salt in the gold plating solution is 0.1 to 10 g/L in terms of gold metal. The gold plating solution may contain a gold alloy which can form a gold alloy plating film.

Method for manufacturing electronic component

As described above, the method for manufacturing an electronic component according to the present invention is characterized by comprising forming a germanium-containing nickel plating film on a surface of an electroconductive base material in the connecting terminal part using a germanium-containing nickel plating bath.

In one preferred embodiment of the present invention, the concentration of germanium in the nickel plating bath used in the method for manufacturing the electronic component according to the present invention is 0.1 to 10000 ppm, preferably 10 to 5000 ppm, more preferably 10 to 1000 ppm, still more preferably 10 to 500 ppm.

In one preferred embodiment of the present invention, the nickel plating bath in the method for manufacturing the electronic component according to the present invention is a Watts bath or a sulfamic acid bath.

In the method according to the present invention, the addition of a water soluble Ge compound to a conventional nickel plating bath and the management of the concentration of germanium in the nickel bath suffice for contemplated results, and changing conventional plating conditions is not always necessary.

In another preferred embodiment of the present invention, the method for manufacturing an electronic component according to the present invention comprises forming a palladium plating film or a gold plating film on the surface of the nickel plating film.

In another more preferred embodiment of the present invention, the method for manufacturing an electronic component according to the present invention comprises forming a palladium plating film on the surface of the nickel plating film and further forming a gold plating film on the surface of the palladium plating film.

### EXAMPLES

The present invention is further illustrated by the following Examples that are not intended as a limitation of the invention.

### Example 1

In Example 1, a bonding part for bonding to solder was formed in an electronic component using a nickel plating solution, and the solder wettability of the bonding part was then evaluated.

### (1) Preparation of evaluation samples

Copper (Cu) alloy lead frames were first provided. Nickel plating, palladium plating, and gold plating were successively carried out on the surface of a part as a connecting terminal part in the Cu alloy lead frames under the following conditions to form a nickel plating film, a palladium plating film, and a gold plating film. The plated lead frames were used as evaluation samples. Fig. 1 is a conceptual diagram of a three-layered plating structure formed on a conventional lead frame (Cu alloy lead frame) material.

### i) Nickel plating treatment:

| | | |
|---|---|---|
| · Nickel sulfamate plating solution | | |
| | Nickel sulfamate | 450 g/l |
| | Nickel bromide | 10 g/l |
| | Boric acid | 30 g/l |
| · Germanium oxide (in terms of germanium metal) ppm | | 0, 1, 10, 50, 100, and 1000 |
| · Solution temperature | | 55°C |
| · Current density | | 3 A/dm² |

### ii) Palladium plating treatment:

| | |
|---|---|
| · Palladium plating solution (manufactured by MATSUDA SANGYO CO., LTD., Palla Sigma LA-5). | |
| · Concentration of palladium | 5 g/l |
| · pH | 8.5 |
| · Solution temperature | 55°C |
| · Current density | 0.5 A/dm² |

### iii) Gold plating treatment:

| | | |
|---|---|---|
| · Gold plating solution | | |
| | Gold potassium cyanide | 2 g/l |
| | Citric acid | 50 g/l |
| | Potassium citrate | 70 g/l |
| · Solution temperature | | 55°C |
| · Current density | | 0.1 A/dm² |

Specifically, at the outset, the provided Cu alloy lead frames were subjected to electrolytic degreasing treatment (direct-current power supply device, solution temperature 60°C, applied voltage 5V, immersion time 120 seconds) as pretreatment to remove contaminants and oxides present on the surface of the lead frames. The lead frames were then pickled (5% sulfuric acid, 30 sec), were washed with pure water, and were then plated with nickel for each of the above germanium contents. After the treatment, the nickel plated lead frames were washed with pure water and were then subjected to the palladium plating treatment. The plated lead frames were then washed with water, were subjected to the gold plating treatment, and were dried to prepare evaluation samples.

The plating treatment was carried out to form a plating film with a thickness of 1 µm for nickel, a plating film with a thickness of 0.01 µm for palladium, and a plating film with a thickness of 0.007 µm for gold.
For the evaluation samples prepared above, samples for a germanium content of 0 ppm, a germanium content of 1 ppm, a germanium content of 10 ppm, a germanium content of 50 ppm, a germanium content of 100 ppm, and a germanium content of 1000 ppm in the nickel plating bath used in the nickel plating treatment were used as evaluation sample 1 (comparative example), sample 2 (present invention), sample 3 (present invention), sample 4 (present invention), sample 5 (present invention), and sample 6 (present invention), respectively.

The amount of germanium (Ge) codeposited in the nickel plating film for each of the evaluation samples was measured with an inductively coupled plasma (ICP) emission spectroscopic analyzer manufactured by SII NanoTechnology Inc.

Based on the results thus obtained, the relationship between the concentration of germanium in the nickel plating bath and the content of germanium in the nickel plating film formed using the nickel plating bath having each of the germanium concentrations was determined. The results are shown in Table 1 and Fig. 2.

[Table 1]

**Table1:**

| Evaluation sample | Concentration of Ge in Ni plating bath (ppm) | Content of Ge in Ni plating film (wt%) |
|---|---|---|
| Sample 1 | 0 | 0 |
| Sample 2 | 1 | 0.005 |
| Sample 3 | 10 | 0.16 |
| Sample 4 | 50 | 0.50 |
| Sample 5 | 100 | 0.83 |
| Sample 6 | 1000 | 3.64 |

### (2) Evaluation of solder wettability (zero crossing time (ZCT) test)

The evaluation samples were held under predetermined heating temperature conditions (400 ± 2°C) for a given period of time to undergo a high-temperature heat history and were immersed in a solder bath (63% tin-37% lead, solution temperature 230 ± 5°C). Thereafter, for the samples, the time necessary for the force received from the solder bath to become 0 (zero) (zero crossing time (sec)) was measured to evaluate solder wettability.

In this case, the shorter the zero crossing time, the better the solder wettability.

### a) Influence of sample heating time on solder wettability

The sample 5 (present invention) in which the concentration of germanium in the nickel plating bath during the plating treatment was 100 ppm and the sample 1 (comparative example) corresponding to a conventional product and free from germanium were provided as evaluation samples. For the evaluation samples, the relationship between the heating time (sec) for heating of the evaluation samples to 400 ± 2°C and the zero crossing time (solder wettability) was determined.

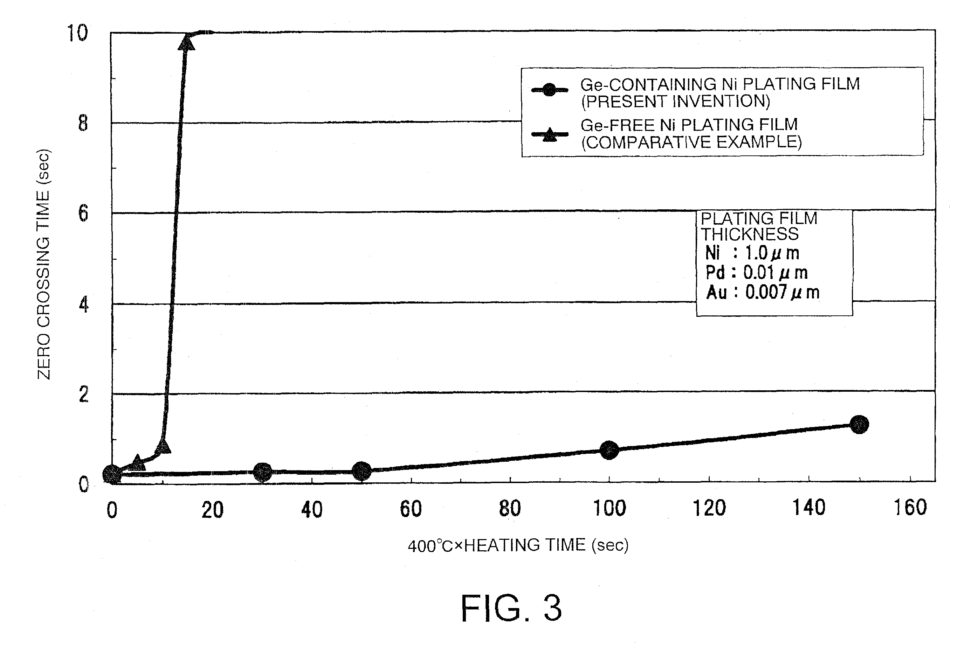

The results were as shown in Fig. 3.

As is apparent from the results, for the germanium-free sample 1, the zero crossing time rapidly increased with increasing the heating time in the heating treatment (for example, increased to about 10 sec when the heating time was 10 sec) resulting in rapidly deteriorated solder wettability. On the other hand, for the sample provided with a germanium-containing nickel plating film (sample 5), the zero crossing time did not significantly increased even when the heating time was increased, and the zero crossing time was maintained at a relatively small value. In this case, for example, even when the heating time was 100 sec, the zero crossing time was maintained at a value below one sec. That is, for the sample provided with the germanium-containing nickel plating film, the solder wettability could be maintained even when the sample was subjected to a severe heat history.

### b) Influence of content of germanium in nickel plating film on solder wettability

For the evaluation samples 1 and 3 to 6, the zero crossing time was measured under heating conditions of heating temperature 400 ± 2°C and heating time 30 sec to evaluate the relationship between the content of germanium in the nickel plating film and the solder wettability.

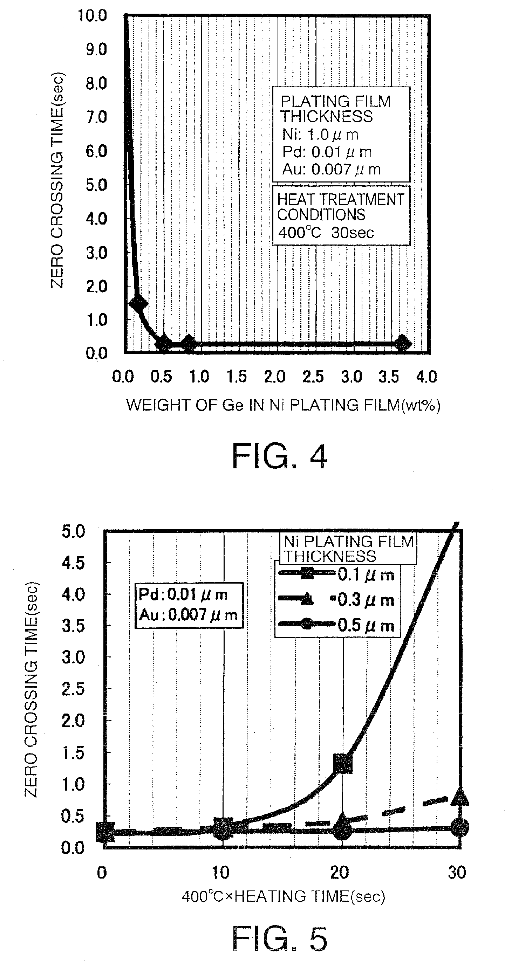

The results were as shown in Table 2 and Fig. 4.

[Table 2]

**Table2:**

| Evaluation sample | Content of Ge in Ni plating film (wt%) | Zero crossing time (sec) |
|---|---|---|
| Sample 1 | 0 | Not solderable |
| Sample 3 | 0.16 | 1.48 |
| Sample 4 | 0.50 | 0.25 |
| Sample 5 | 0.83 | 0.26 |
| Sample 6 | 3.64 | 0.28 |

As is apparent from the results, when the nickel plating film contained germanium, the solder wettability was significantly improved.

### Example 2

Evaluation samples were produced in the same manner as in Example 1, except that the nickel plating film was formed to thicknesses of 0.1 µm, 0.2 µm, and 0.5 µm using a nickel plating bath having a germanium concentration of 100 ppm.

For the samples respectively having nickel plating film thicknesses of 0.1 µm, 0.3 µm, and 0.5 µm, the relationship between the heating time (sec) for heating of the evaluation samples to 400 ± 2°C and the zero crossing time (solder wettability) was determined in the same manner as in Example 1.

The results were as shown in Fig. 5.

As is apparent from the results, the desired solder wettability could be maintained even when the thickness of the nickel plating film was reduced to a certain level. Further, it was expected that, even when the plating film thickness is smaller, the desired solder wettability could be maintained by regulating the germanium content.

### Example 3

The samples 1 and 5 produced in Example 1 were heat treated in the air under conditions of 400°C and 30 sec. Thereafter, the behavior of diffusion of nickel from the nickel layer in the three-layered plating film was analyzed in the depth direction (depth profile) with an X-ray photoelectron spectroscopic analyzer (XPS) (Japan Electron Optics Laboratories (JEOL Ltd.), JPS-9010MX).

As described above, the sample 1 (comparative example) comprised a germanium-free nickel plating film (film thickness 1 *m), a palladium plating film (film thickness 0.01 µm), and a gold plating film (film thickness 0.007 µm) provided in that order on an electroconductive base material (a copper based mental) in a Cu alloy lead frame. The sample 5 (present invention) was the same as the sample 1, except that the nickel plating film contained 0.83% by weight of germanium.

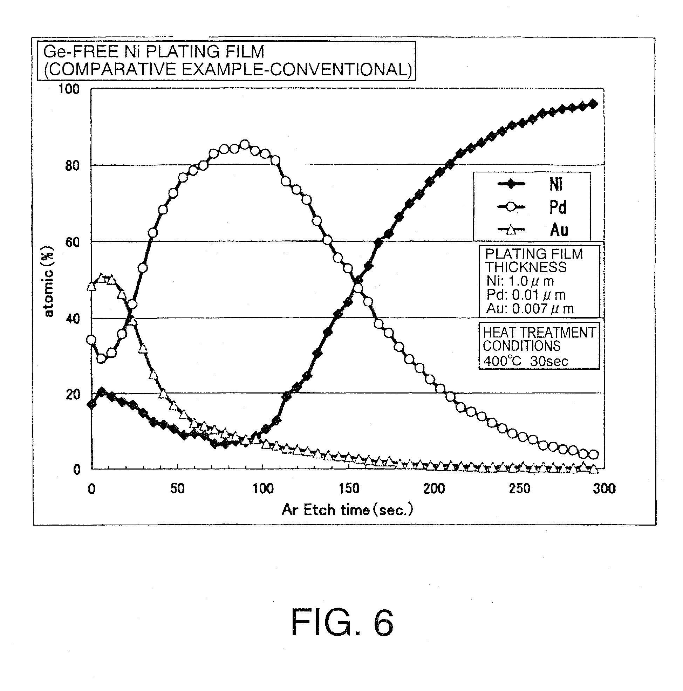

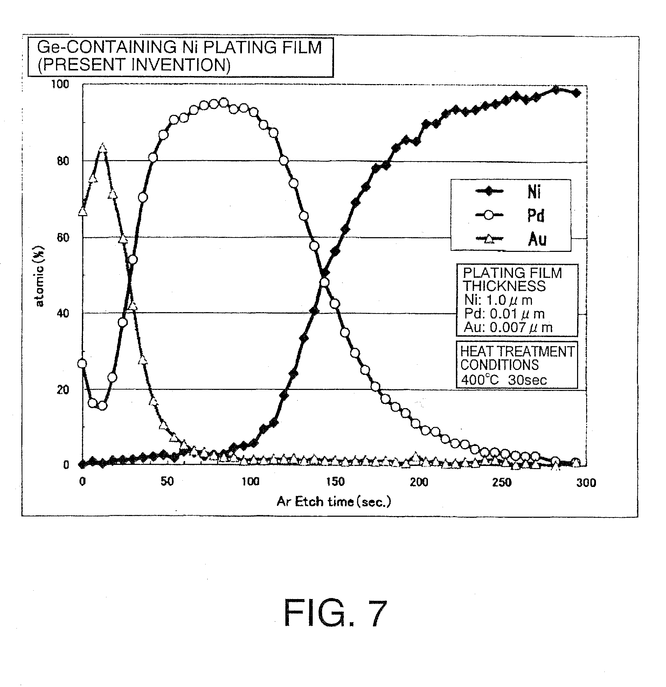

The results were as shown in Fig. 6 (results for the sample 1 (comparative example)), and Fig. 7 (results for sample 5 (present invention)).

In the drawing, the abscissa represents the depth from the surface layer of the three-layered plating film, and the ordinate represents the content of each of nickel, palladium, and gold in the depth. Accordingly, if the three-layered plating film is analyzed without the heat treatment, then in a graph of depth profile, as viewed from the plating film on its side, which provides a smaller value on the abscissa, that is, the surface layer side of the plating film, at the outset, a part close to the surface layer has a high gold content. Subsequently, as the distance from the surface of the plating film increases, that is, the depth increases, the content of palladium increases. As the depth further increases, the content of nickel increases. This tendency can be seen from Figs. 6 and 7.

Fig. 6 shows that, in the nickel plating film free from germanium, nickel was diffused from the nickel layer to palladium layer or the gold layer. That is, it could be confirmed that nickel was present in a deeper portion from the surface layer or a portion close to the surface layer of the three-layered plating film. This means that nickel is diffused by the heat treatment to a portion closer to the surface layer, that is, to the palladium layer and the gold layer and nickel is precipitated even on the outermost surface.

On the other hand, the profile shown in Fig. 7 is utterly different from the profile shown in Fig. 6. In Fig. 7, nickel was hardly observed in the surface layer and a portion close to the surface layer and was at last observed around a portion close to the end of the palladium layer. That is, for the sample 5 (present invention) in Fig. 7, significant diffusion of nickel into layers located near the surface side rather than the nickel plating film was hardly observed. This fact means that the presence of germanium in the nickel plating film suppressed the diffusion of nickel into the surface layer.

## Claims

1. An electronic component comprising a connecting terminal part having a surface of an electroconductive base material and a germanium-containing nickel plating film provided on the surface.

2. The electronic component according to claim 1, which has a two-layered plating structure comprising a palladium plating film provided on the surface of the nickel plating film or a gold plating film provided on the surface of the nickel plating film.

3. The electronic component according to claim 2, which has a three-layered plating structure comprising a palladium plating film provided on the surface of the nickel plating film and a gold plating film provided on the surface of the palladium plating film.

4. The electronic component according to any one of claims 1 to 3, wherein the thickness of the nickel plating film is 0.01 to 5 µm.

5. The electronic component according to any one of claims 1 to 4, wherein the nickel plating film has a germanium content of 0.005 to 10% by weight.

6. The electronic component according to any one of claims 1 to 5, wherein the connecting terminal part is subjected to soldering or wire bonding.

7. The electronic component according to any one of claims 1 to 6, which is a package comprising any of a lead frame, an organic substrate, or an inorganic substrate.

8. An electrical product comprising an electronic component according to any one of claims 1 to 7.

9. A method for manufacturing an electronic component, which comprises forming a germanium-containing nickel plating film on a surface of an electroconductive base material in the connecting terminal part by using a germanium-containing nickel plating bath.

10. The method according to claim 9, wherein the concentration of germanium in the nickel plating bath used is 0.1 to 10000 ppm.

11. The method according to claim 9 or 10, wherein the nickel plating bath is a Watts bath or a sulfamic acid bath.

12. The method according to any one of claims 9 to 11, which further comprises forming a palladium plating film or a gold plating film on the surface of the nickel plating film.

13. The method according to claim 12, wherein the palladium plating film is formed on the surface of the nickel plating film followed by the formation of the gold plating film on the surface of the palladium plating film.
